# EUROPÄISCHE PATENTSCHRIFT

(11) **EP 2 288 943 B1**
(45) Veröffentlichungstag und Bekanntmachung des Hinweises auf die Patenterteilung: **18.12.2019**
(21) Anmeldenummer: 09765456.0
(22) Anmeldetag: 18.06.2009
(51) Int. Cl.: G01V 8/10, H01L 31/173, H01L 31/0232

(54) **LICHTSCHRANKE SOWIE VERFAHREN ZUM DETEKTIEREN VON OBJEKTEN**
LIGHT BARRIER AND METHOD FOR DETECTING OBJECTS
BARRIÈRE OPTIQUE ET PROCÉDÉ DE DÉTECTION D'OBJETS

(30) Priorität: 20.06.2008 DE 102008029467
(43) Veröffentlichungstag der Anmeldung: 02.03.2011
(73) Patentinhaber: OSRAM Opto Semiconductors GmbH, 93055 Regensburg (DE)
(72) Erfinder: HAAS, Heinz, 93059 Regensburg (DE); GIZIEWICZ, Wojciech, 74081 Heilbronn (DE)
(74) Vertreter: Zacco Patent- & Rechtsanwälte
(86) Internationale Anmeldenummer: PCT/DE2009/000864
(87) Internationale Veröffentlichungsnummer: WO 2009/152820

(56) Entgegenhaltungen:
- EP-A1- 1 722 191
- EP-A2- 0 499 945
- DE-A1- 10 201 746
- DE-A1- 19 644 565
- DE-A1- 19 912 720
- DE-A1-102006 011 191
- JP-A- 2004 279 389
- US-A- 4 716 298
- US-A1- 2007 090 282
- US-A1- 2007 170 380
- US-B1- 6 486 467

## Beschreibung

Die Erfindung betrifft eine Lichtschranke sowie ein Verfahren zum Detektieren von Objekten mit einem Träger, einem eine elektromagnetische Strahlung detektierenden Halbleiterchip und einem neben oder über dem detektierenden Halbleiterchip angeordneten und speziell ausgeformten und/oder platzierten richtungsselektiven Element.

Zum Detektieren von Objekten in einem zu untersuchenden Bereich oder Gebiet sind eine Vielzahl von Möglichkeiten bekannt. Eine Möglichkeit, um Objekte zu detektieren, ist der Einsatz von Lichtschranken. Im folgenden werden unter dem Begriff Lichtschranke ebenso die Begriffe Näherungssensor und Bewegungssensor verstanden. Eine Lichtschranke ist ein elektronisch-optisches System mit zumindest einem Emitter und zumindest einem Detektor. Als Emitter wird ein eine elektromagnetische Strahlung aussendender Halbleiterchip angesehen. Der Emitter wird auch als Sender oder Strahlungsquelle bezeichnet. Der Detektor hingegen ist ein eine elektromagnetische Strahlung detektierender Halbleiterchip, welcher auch als Sensor oder Empfänger bezeichnet wird.

Das Funktionsprinzip einer Lichtschranke wird im folgenden kurz erläutert. Der Emitter sendet eine elektromagnetische Strahlung eines bestimmten Wellenlängenbereich mit einer entsprechenden Lichtstärke I aus. Der Detektor ist zumindest für diesen bestimmten Wellenlängenbereich der Strahlung sensitiv. Durch ein zu detektierendes Objekt in der Lichtschranke wird der Strahlengang zwischen Emitter und Detektor verändert. Im Detektor wird die resultierende Veränderung der auftreffenden Leuchtdichte der Strahlung registriert. Diese Registrierung wird in einem Folgeschritt in ein elektrisches Schaltsignal umgesetzt, welches anschließend weiter verarbeitet wird.

Als Leuchtdichte L ist es das Verhältnis der ausgestrahlten Lichtstärke I zur Größe A ihrer scheinbaren leuchtenden Fläche definiert. Die Leuchtdichte hat die SI-Einheit Candela cd pro Quadratmeter m². Die Leuchtdichte ist die fotometrische Entsprechung zur Strahlungsdichte L(A) mit der Einheit Watt*Meter⁻²*Steradiant⁻¹ bzw. W·m⁻²·sr⁻¹ der Radiometrie.

Man unterscheidet Lichtschranken prinzipiell zwischen Einweglichtschranken und Reflexlichtschranken. Bei Einweglichtschranken stehen sich Emitter und Detektor gegenüber, wobei die Hauptabstrahlrichtung des Emitters direkt in Richtung Detektor liegt. Der Detektor detektiert demnach ständig die Leuchtdichte, die vom Emitter verursacht wird. Sobald ein Objekt in den Strahlengang zwischen Emitter und Detektor tritt, wird der Strahlengang unterbrochen. Das daraus folgende Nichtdetektieren der ausgesendeten Strahlung des Emitters wird in einer weiter verarbeitenden Einheit ausgewertet.

Bei Reflexlichtschranken stehen sich im Unterschied zur Einweglichtschranke Emitter und Detektor nicht gegenüber und befinden sich darüber hinaus bevorzugt in einem gemeinsamen Gehäuse. Dadurch ist der Aufbau weniger aufwendig. Prinzipiell werden bei Reflexlichtschranken zwei Methoden zum Detektieren von Objekten unterschieden.

Bei der ersten Methode ist ein reflektierendes Element auf einer ersten Seite, das Gehäuse mit Emitter und Detektor auf einer gegenüberliegenden Seite angeordnet. Das Element und das Gehäuse sind derart ausgerichtet, dass eine Unterbrechung des Strahlengangs durch ein Objekt, eine Leuchtdichteänderung im Detektor hervorruft.

Alternativ wird kein Reflektor verwendet. Ist ein Objekt im Strahlengang des Emitters, so trifft die Strahlung des Emitters auf das Objekt und wird an der Objektoberfläche aufgrund der Oberflächengestaltung des Objektes gestreut. Durch die Streuung wird ein Teil der ausgesendeten Strahlung auf den Detektor treffen. Die Änderung der Leuchtdichte im Detektor wird registriert.

Ein generelles Problem bei der Ausgestaltung von Lichtschranken ist der Einfluss von Umweltgrößen, beispielsweise Tageslicht, Fremdlicht oder ähnlichem.

Zunehmend werden Detektor und Emitter auf einem Träger innerhalb eines Gehäuses untergebracht. Dadurch lassen sich elektrische Ansteuerungen vereinfacht ausgestalten. Dadurch ist ein weiteres Problem bei der Ausgestaltung von Lichtschranken, das so genannte Nebensprechen zwischen dem aussendenden Halbleiterchip und dem detektierenden Halbleiterchip zu beachten. Dieses Nebensprechen tritt auf, wenn beispielsweise Strahlung auf direktem Weg vom Emitter in den Detektor eingekoppelt wird, bevor diese Strahlung das Gehäuse verlassen hat. Das Nebensprechen tritt ebenfalls auf, wenn die Strahlung innerhalb des Gehäuses reflektiert wird und auf den Detektor trifft. Die Strahlung, die durch Nebensprechen auf den Detektor gelangt, verändert den Arbeitspunkt auf der Kennlinie des Detektors. Durch die Arbeitspunktänderung wird die Empfindlichkeit des Detektors mitunter stark verschlechtert. Um die Empfindlichkeit einer Lichtschranke zu steigern ist stets angestrebt die Umwelteinflüsse und das Nebensprechen zu minimieren.

In der Druckschrift US 2007/0170380 A1 wird eine Detektoreinheit zur Detektion sich bewegender Objekte angegeben.

Die Druckschrift DE 199 12 720 A1 betrifft eine optoelektronische Baugruppe.

Eine sich bewegende Objekte feststellende Überwachungseinrichtung ist in der Druckschrift DE 196 44 565 A1 beschrieben.

Ein optoelektronischer Berührungssensor findet sich in der Druckschrift EP 0 499 945 A2.

In der Druckschrift EP 1 722 191 A1 ist eine Abstandsbestimmung offenbart.

Ein optischer Encoder ist in der Druckschrift US 2007/0090282 A1 wiedergegeben.

Die Druckschrift DE 102 01 746 A1 beschäftigt sich mit einer optoelektronischen Vorrichtung.

Aus der Druckschrift DE 10 2006 011 191 A1 sind ein optischer Sensor und ein Verfahren zur Unterdrückung von Streulicht bekannt.

Die Druckschrift US 4,716,298 A betrifft ein System zur automatischen Detektion von Fahrzeugen.

Aus der Druckschrift US 6,486,467 B1 ist ein Detektor zur Bestimmung der relativen Positionen von Objekten zueinander bekannt.

Ein Bewegungsdetektor findet sich in der Druckschrift JP 2004-279389 A.

Es ist Aufgabe der Erfindung, eine Lichtschranke sowie ein Verfahren zum Detektieren von Objekten vorzusehen, bei dem die Empfindlichkeit zum Detektieren von Objekten erhöht ist.

Diese Aufgabe wird durch eine Lichtschranke mit einem Halbleiterbauelement gemäß Anspruch 1 sowie durch ein Verfahren zum Detektieren von Objekten gemäß Anspruch 9 gelöst. Weitere vorteilhafte Ausgestaltungen sind in den Unteransprüchen aufgezeigt.

Die Lichtschranke umfasst ein Halbleiterbauelement. Das Halbleiterbauelement beinhaltet einen Träger mit einer Trägeroberseite. An der Trägeroberseite sind wenigstens zwei elektromagnetische Strahlung detektierende Halbleiterchips und zumindest ein elektromagnetische Strahlung aussendender Halbleiterchip angebracht. Die Halbleiterchips sind zur Detektion beziehungsweise zur Emission von sichtbarer oder, bevorzugt, nahinfraroter Strahlung eingerichtet.

Die Lichtschranke weist mehrere richtungsselektive Elemente an der Oberseite des Trägers auf. Die richtungsselektiven Elemente sind insbesondere mindestens einem der detektierenden und/oder der strahlungsaussendenden Halbleiterchips zugeordnet. Über die richtungsselektiven Elemente ist ein Winkelbereich einer von den Halbleiterchips zu empfangenden Strahlung beziehungsweise einer vom Halbleiterchip zu emittierenden Strahlung eingegrenzt. Mit anderen Worten wird beispielsweise eine Abstrahlcharakteristik des Strahlung aussendenden Halbleiterchips durch das richtungsselektive Element so eingegrenzt oder eingestellt, dass in bestimmte Raumwinkelbereiche keine oder im Wesentlichen keine vom aussendenden Halbleiterchip generierte Strahlung zu den detektierenden Halbleiterchips dringt. Im Hinblick auf die detektierenden Halbleiterchips bedeutet eingegrenzt, dass aus einem bestimmten Winkelbereich keine oder im Wesentlichen keine Strahlung auf die detektierenden Halbleiterchips gelangen kann. Das heißt, über die richtungsselektiven Elemente ist ein Winkel eingegrenzt, aus dem von dem Halbleiterbauelement Strahlung detektierbar, also empfangbar, beziehungsweise in den von dem Halbleiterbauelement Strahlung emittierbar ist.

Bei der Lichtschranke ist mindestens eine Hauptstrahlachse der empfangbaren Strahlung gegenüber wenigstens einer Hauptstrahlachse der zu emittierenden Strahlung verkippt. Die Hauptstrahlachse ist zum Beispiel eine Symmetrieachse oder eine optische Achse der von den Halbleiterchips zu emittierenden oder zu empfangenden Strahlung, oder auch eine Richtung, in der ein Intensitätsmaximum der Strahlung verläuft.

Dies kann bedeuten, dass das beispielsweise dem Strahlung aussendenden Halbleiterchip zugeordnete, richtungsselektive Element eine Abstrahlcharakteristik dieses Halbleiterchips derart eingrenzt oder vorgibt, sodass die optische Achse, die Richtung, in die das Intensitätsmaximum der Strahlung emittiert wird und/oder die Symmetrieachse der emittierten Strahlung nicht parallel zur entsprechenden Hauptstrahlachse der zu empfangenden Strahlung orientiert ist. Anders ausgedrückt stimmt eine optische Achse des Strahlung aussendenden Halbleiterchips und/oder der Strahlung detektierenden Halbleiterchips bevorzugt nicht mit einer mechanischen und/oder optischen und/oder Symmetrieachse des dem Halbleiterchip zugeordneten richtungsselektiven Elements überein. Bezüglich der detektierenden Halbleiterchips kann die Hauptstrahlachse auch eine Richtung sein, aus der gesehen die meiste Strahlung auf den Halbleiterchip oder auf eine Strahlung empfindliche Fläche des Halbleiterchips treffen kann.

Zur Bestimmung der jeweiligen Hauptstrahlachsen ist also sowohl eine Abstrahlcharakteristik beziehungsweise Empfangscharakteristik des jeweiligen aussendenden oder detektierenden Halbleiterchips als auch die Änderung dieser Abstrahlcharakteristik oder Empfangscharakteristik durch das gegebenenfalls dem Halbleiterchip zugeordnete richtungsselektive Element zu berücksichtigen.

Gemäß zumindest einer Ausführungsform der Lichtschranke beträgt ein Winkel zwischen den Hauptstrahlachsen der detektierenden Halbleiterchips und des aussendenden Halbleiterchips, unter Berücksichtigung des gegebenenfalls zugehörigen richtungsselektiven Elements, zwischen einschließlich 5° und 65°, insbesondere zwischen einschließlich 15° und 45°, bevorzugt zwischen einschließlich 20° und 40°.

Bei der Lichtschranke sind die richtungsselektiven Elemente je durch eine Barriere gebildet. Es sind bei der Lichtschranke ein Halbleiterbauelement mit einem Träger, mehrere auf einer Oberseite des Trägers aufgebrachte und eine elektromagnetische Strahlung detektierende Halbleiterchips und mehrere neben den detektierenden Halbleiterchips an oder auf der Oberseite des Trägers aufgebrachte Barrieren vorgesehen, wobei die Barrieren aus einem für die zu detektierende elektromagnetische Strahlung undurchlässigen Material bestehen. Die Barrieren sind beabstandet von den detektierenden Halbleiterchips angeordnet und sind derart geformt, sodass bei senkrechter Parallelprojektion der Barrieren und der detektierenden Halbleiterchips auf die Oberseite des Trägers die projizierten Flächen der Barrieren und die projizierten Flächen der detektierenden Halbleiterchips zumindest teilweise überlappen.

Durch die angegebene Ausgestaltung des Halbleiterbauelements der Lichtschranke wird zunächst der Bereich, in dem ein Detektor ein Objekt detektieren kann, begrenzt eingeschränkt. Diese Einschränkung verringert zusätzlich die Leuchtdichte, die durch Umwelteinflüsse, beispielsweise Tageslicht, Fremdbeleuchtung oder der gleichen auf den Detektor trifft. Durch Beschränken des zu detektierenden Bereiches wird der Einfluss dieser Umweltgrößen zum Detektieren von Objekten minimiert und dadurch der Arbeitspunkt des Detektors stabilisiert.

Das Halbleiterbauelement der Lichtschranke weist zumindest einen eine elektromagnetische Strahlung aussendenden Halbleiterchip auf, wobei die Barrieren jeweils zwischen Detektor und Emitter angeordnet sind. Auf diese Art ist zusätzlich ein Nebensprechen von der ausgesendeten Strahlung auf die detektierenden Halbleiterchips minimiert. Durch diese teilweise Überlappung der projizierten Flächen ist sichergestellt, dass ein so genanntes Nebensprechen, beispielsweise verursacht durch die Gehäusebeschaffenheit des Halbleiterbauelements, nicht auf den Detektor treffen. Dadurch ist das so genannte Eigenrauschen des Detektors verringert, der optimale Arbeitspunkt des Detektors wird beibehalten und eine höhere Empfindlichkeit ist erzielt.

Die richtungsselektiven Elemente, also die Barrieren, sind in einer Ausgestaltung mittels eines Klebemittels auf der Oberseite des Trägers aufgebracht. Dieses Klebemittel ist vorzugsweise ebenfalls absorbierend oder reflektierend für die zu detektierende Strahlung. Alternativ können die richtungsselektiven Elemente auch mittels Spritzguss oder Spritzpressverfahren als Teil eines Gehäuses des Halbleiterbauelements gefertigt sein. In dieser Ausgestaltung ist kostengünstig ein Halbleiterbauelement hergestellt.

Bei der Lichtschranke sind mindestens zwei die Strahlung detektierende Halbleiterchips auf der Oberseite des Trägers aufgebracht. Zwischen den Detektoren und dem Emitter ist jeweils eine Barriere auf der Oberseite des Trägers vorgesehen. Alle Detektoren detektieren eine Strahlung. Die Veränderung der Leuchtdichte, verursacht durch das Objekt, wirkt auf die Detektoren. Mittels einer Vergleichseinheit lassen sich Detektorsignale auswerten.

Befinden sich zwei Detektoren und ein Emitter in dem Halbleiterbauelement, so ist eine Relativbewegung eines Objektes zum aussendenden Halbleiterchip detektierbar. Es lassen sich so vereinfacht Aussagen darüber treffen, ob das Objekt links vom, rechts vom oder direkt über dem aussendenden Halbleiterchip ist. Befinden sich mehr als zwei Detektoren im Halbleiterchip, so ist eine zweidimensionale Ortung des Objektes möglich.

Zusätzlich ist in einer weiteren Ausgestaltung vorgesehen, weitere Strahlung aussendende Halbleiterchips in dem Halbleiterbauelement anzuordnen. Die Emitter werden hierbei in einem Zeitmultiplexverfahren betrieben, wobei die aussendenden Halbleiterchips entweder amplitudenmoduliert oder nicht amplitudenmoduliert sind. Das Zeitmultiplexverfahren wird angewendet, um einem Detektor über ein Zeitmanagement mitzuteilen, welche Strahlung gerade detektiert wird. Andere Verfahren, wie Frequenz-, Code- oder Wellenlängenmultiplexverfahren sind ebenfalls denkbar. Der Detektor erfährt dann durch eine geeignete Demultiplexeinheit, wessen Strahlung der aussendenden Halbleiterchips detektiert wird.

Um weitere Störeinflüsse der Strahlung zu vermeiden wird das Signal in bevorzugter Weise amplitudenmoduliert. Dieses Modulieren wird auch als "Burst-Mode" Übertragung bezeichnet. Mittels dieser "Bursts" von Trägerwellen sind weitere Störeinflüsse der Umwelt verhindert.

Durch Einbringen einer Vielzahl von Detektoren und Emittern ist die Auflösung des zu untersuchenden Bereiches erheblich erhöht und eine genauere Aussage über den Ort des jeweiligen Objektes in relativer Position zum Strahlung aussendenden Halbleiterchip möglich.

Die Formgebung der richtungsselektiven Elemente ist hierbei nicht limitiert. Beispielsweise sind L-förmige, bogenförmige oder auch schräg geformte Barrieren vorgesehen. Zur Verbesserung der Empfindlichkeit des Detektors ist stets darauf zu achten, dass die projizierten Flächen sich teilweise überlappen. In anderen Worten, es ist grundsätzlich anzustreben, dass die detektierenden Halbleiterchips im Strahlungsschatten des auszusendenden Halbleiterchips ist.

In einer weiteren Ausgestaltung ist zumindest ein optisches Element im Strahlengang des Emitters beziehungsweise des Detektors eingebracht. Hierdurch ist eine verbesserte Strahlführung möglich und eine Empfindlichkeitssteigerung erzielt. In einer Ausgestaltung sind die detektierenden Halbleiterchips je ein Fototransistor, eine Fotodiode beziehungsweise ein Fotowiderstand.

Der aussendende Halbleiterchip ist bevorzugt eine Laserdiode oder eine LED. Die Wellenlänge der auszusendenden und zu detektierenden Strahlung ist in dieser Erfindung in keiner Weise auf einen bestimmten Bereich beschränkt. Die auszusendende Strahlung ist bevorzugt im Nah-Infrarotwellenlängenbereich. Ebenfalls im ultravioletten Bereich oder auch im sichtbaren Bereich des elektromagnetischen Spektrums ist ein Detektieren von Objekten möglich.

Gemäß zumindest einer Ausführungsform der Lichtschranke, bei der diese bevorzugt eine Mehrzahl von detektierenden Halbleiterchips und von Strahlung aussendenden Halbleiterchips umfasst, sind die Hauptstrahlachsen eines überwiegenden Anteils oder aller detektierenden Halbleiterchips und aller Strahlung aussendenden Halbleiterchips jeweils gegeneinander verkippt ausgerichtet. Mit anderen Worten weisen zum Beispiel keine zwei detektierenden und empfangenden Halbleiterchips Hauptstrahlachsen mit einer gleichen Orientierung, insbesondere bezogen auf die Oberseite des Trägers, auf. Es ist hierbei möglich, dass eine Hauptstrahlachse eines detektierenden Halbleiterchips dieselbe Orientierung aufweist wie eine Hauptstrahlachse eines Strahlung aussendenden Halbleiterchips.

Gemäß zumindest einer Ausführungsform der Lichtschranke sind die Strahlung detektierenden Halbleiterchips je ein applikationsspezifischer integrierter Schaltkreis, englisch application specific integrated circuit oder kurz ASIC.

Gemäß zumindest einer Ausführungsform der Lichtschranke sind die richtungsselektiven Elemente formschlüssig zu den detektierenden Halbleiterchips und/oder zu dem Strahlung aussendenden Halbleiterchip geformt. Formschlüssig kann bedeuten, dass der Halbleiterchip eine Passform bezüglich des zugehörigen richtungsselektiven Elements aufzeigt. Zum Beispiel ist der Halbleiterchip an mindestens zwei Begrenzungsflächen zumindest stellenweise von dem zugehörigen richtungsselektiven Element umschlossen.

Gemäß einer nicht-erfindungsgemäßen Abwandlung der Lichtschranke ist das richtungsselektive Element durch einen Linsenkörper gebildet, wobei der Linsenkörper an den Halbleiterchip angeformt ist und den Halbleiterchip an mindestens zwei Begrenzungsflächen teilweise oder, bevorzugt, vollständig umgibt. Es ist hierbei möglich, dass das richtungsselektive Element durch einen Spritzprozess oder Gießprozess insbesondere verbindungsmittelfrei direkt an dem Halbleiterchip angebracht ist.

Hier beschriebene Lichtschranken können beispielsweise zur Detektion der Bewegung von Gegenständen oder Körperteilen, insbesondere zur Gestendetektion, Verwendung finden. Beispielweise werden die hier beschriebenen Lichtschranken in Mobiltelefonen, in Tastaturen, bei Navigationssystemen, in elektronischen Geräten, in Rechnern, in tragbaren Rechnern, bei Bedienflächen und/oder im Automobilbereich insbesondere als Hilfsgerät bei der Steuerung oder bei der Dateneingabe eingesetzt.

Schließlich ist ein Verfahren zum Detektieren von Objekten vorgesehen, wobei die Intensität der in den Halbleiterchips detektierten Strahlung in einer nachgeschalteten Auswerteeinheit ausgewertet wird und aufgrund der Höhe der Intensität auf die Entfernung des Objektes zum Halbleiterbauelement geschlossen werden kann. Es wird mittels des Verfahrens eine Lichtschranke betrieben, wie oben beschrieben. Merkmale des Verfahrens sind daher auch für die Lichtschranke offenbart und umgekehrt.

Nachfolgend werden Ausführungsbeispiele der Erfindung in Bezugnahme auf die Figuren näher erläutert. Gleiche oder gleichwirkende Bestandteile sind jeweils mit den gleichen Bezugszeichen gekennzeichnet. Die dargestellten Elemente sind nicht als maßstabsgerecht anzusehen, vielmehr können einzelne Elemente zum besseren Verständnis übertrieben groß beziehungsweise übertrieben vereinfacht dargestellt sein.

Es zeigen:
Figur 1 eine nicht-erfindungsgemäße Abwandlung einer Lichtschranke mit einem Halbleiterbauelement zum Detektieren von Objekten,
Figur 2 ein Ausführungsbeispiel eines Halbleiterbauelements mit alternativer Formgestaltung der Barriere,
Figur 3 ein weiteres Ausführungsbeispiel einer Lichtschranke mit einem Halbleiterbauelement mit alternativer Formgestaltung der Barriere,
Figur 4 ein weiteres Ausführungsbeispiel in Form einer Weiterbildung der in Figur 1 dargestellten Abwandlung,
Figur 5 eine Weiterbildung des in Figur 4 dargestellten Ausführungsbeispiels,
Figur 6 eine Prinzipskizze zum Detektieren von Objekten innerhalb der Anordnung,
Figur 7 eine weitere Prinzipskizze mit einer Weiterbildung des in Figur 4 dargestellten Ausführungsbeispiels,
Figur 8 Signalverläufe der detektierten Strahlungsdichte beider in Figur 6 dargestellten detektierenden Halbleiterchips,
Figur 9 eine Draufsicht auf ein weiteres Ausführungsbeispiel einer Lichtschranke mit einem Halbleiterbauelement zum Detektieren von Objekten,
Figur 10 ein weiteres Ausführungsbeispiel eines Halbleiterbauelements mit alternativer Formgestaltung der Barriere, Figur 11 Signalverläufe des detektierten Fotostromes der in

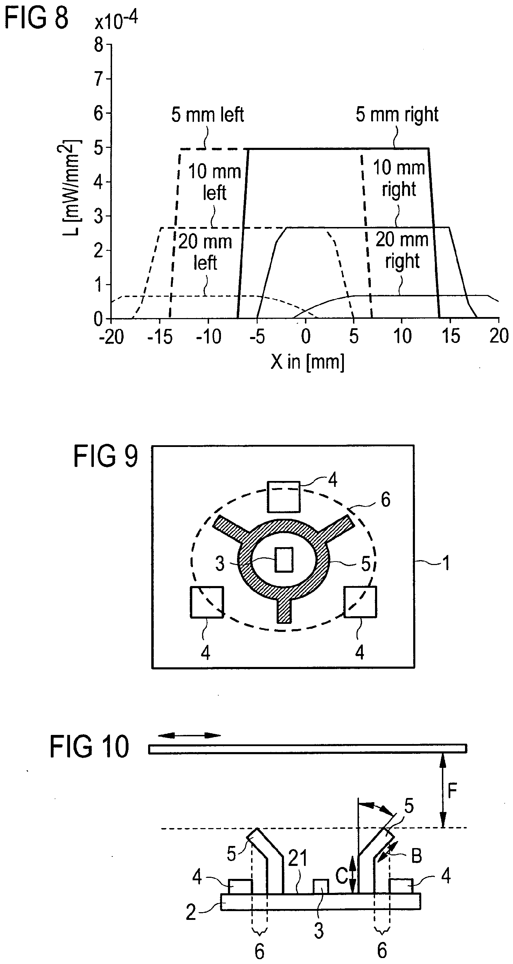

Figur 10 dargestellten detektierenden Halbleiterchips,

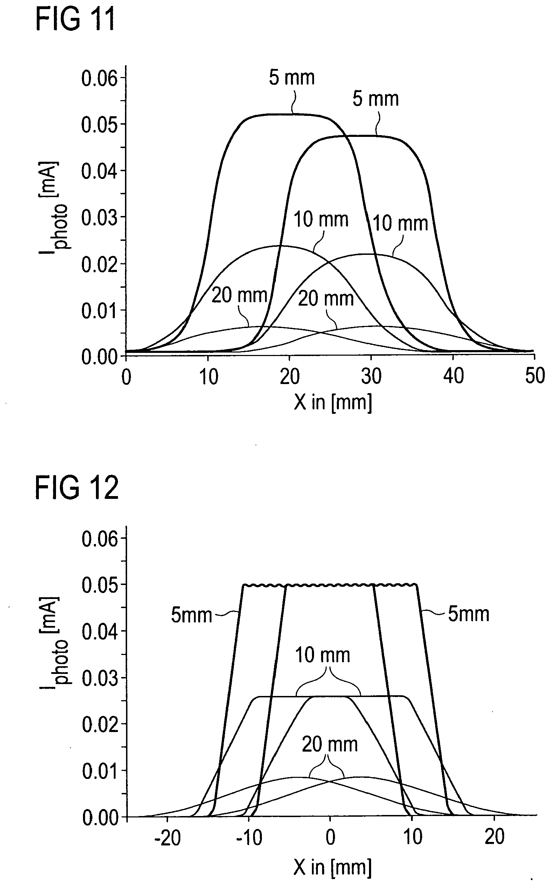

Figur 12 Signalverlauf des simulatorisch ermittelten Fotostroms der in Figur 10 dargestellten detektierenden Halbleiterchips, und

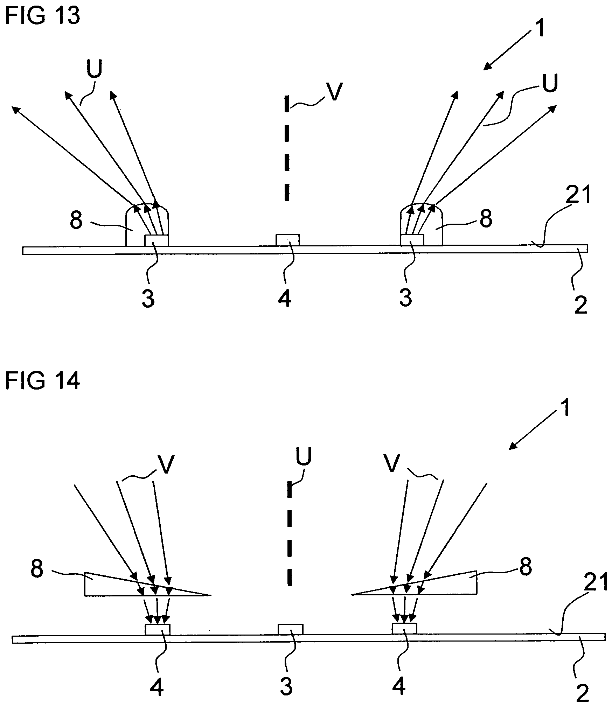

Figuren 13 bis 16 weitere nicht-erfindungsgemäße Abwandlungen der Lichtschranke.

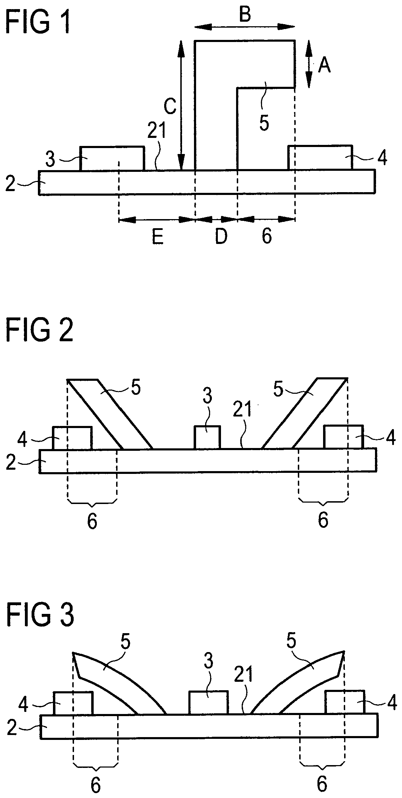

In Figur 1 ist eine nicht-erfindungsgemäße Abwandlung einer Lichtschranke mit einem Halbleiterbauelement 1 dargestellt. Das Halbleiterbauelement 1 weist einen Träger 2 mit einer Oberseite 21 auf. Auf dieser Oberseite 21 ist ein Halbleiterchip 3, der eine Strahlung aussendet, aufgebracht. Weiterhin ist ein Halbleiterchip 4 auf der Oberseite 21 aufgebracht, der eine Strahlung detektiert. Der detektierende Halbleiterchip 4 wird im folgenden als Detektor 4 bezeichnet. Der aussendende Halbleiterchip 3 wird im folgenden als Emitter 3 bezeichnet.

Zwischen Detektor 4 und Emitter 3 auf der Oberseite 21 ist ein richtungsselektives Element, das in Form einer Barriere 5 gestaltet ist, vorgesehen. Durch die Barriere 5 ist ein Winkelbereich einer Strahlung, die vom Detektor 4 empfangbar ist, eingeschränkt. Die Barriere 5 ist derart geformt, dass der Detektor 4 im Strahlungsschatten des Emitters 3 liegt. Dies ist hierbei durch eine, im Querschnitt gesehen, L-Form der Barriere 5 erreicht. Wird eine senkrechte Parallelprojektion auf die Barriere 5 und den Detektor 4 angewendet, so werden die dreidimensionalen Punkte der Barriere 5 und des Detektors 4 senkrecht auf eine Projektionsebene abgebildet. Ist die Projektionsebene die Oberseite 21 des Trägers, so überlappen sich die projizierte Fläche der Barriere 5 und des Detektors 4 zumindest teilweise. Der dargestellte Bereich 6 ist hierbei als Strahlungsschatten der Barriere 5 eingezeichnet, wobei dieser Strahlungsschatten 6 bei senkrecht auf die Oberseite treffenden Strahlungen entsteht und den Detektor 4 zumindest teilweise bedeckt.

Eine Hauptstrahlachse U der von Emitter 3 ausgesendeten Strahlung ist in Figur 1 durch eine Strichlinie symbolisiert. Die ausgesendete Strahlung ist von der Barriere 5 im Wesentlichen unbeeinflusst und daher senkrecht zur Trägeroberseite 21 orientiert. Hingegen eine Hauptstrahlachse V einer vom Detektor 4 empfangbaren Strahlung, ebenfalls symbolisiert durch eine Strichlinie, ist gegenüber der Hauptstrahlachse U des Emitters 3 gekippt. Die Kippung der Hauptstrahlachse U resultiert aus der Abschattung durch die Barriere 5. Zum Beispiel sind die Hauptstrahlachsen U, V durch eine Richtung definiert, in der die meiste Strahlung emittiert wird oder aus der gesehen eine effektive Detektionsfläche des Detektors 4 maximal ist.

Durch diese Formgebung, bei der sich die projizierten Flächen zumindest teilweise Überlappen, so ist das Nebensprechen zwischen Emitter 3 und Detektor 4 sowie der Umwelteinfluss reduziert. Somit können Detektoren, die beispielsweise im Nah-Infrarotbereich Strahlung detektieren, die Bewegung eines Objektes oberhalb des Halbleiterbauelements 1 detektieren.

Befindet sich nun ein Objekt im Strahlengang, so wird die Strahlung des Emitters 3 an der Oberfläche des Objekts zumindest teilweise gestreut und in viele Richtungen zurückgesendet. Die gestreute Strahlung wird nun von dem Detektor 4 zumindest teilweise detektiert.

Die Barriere 5 ist mittels Klebemittel auf der Oberseite 21 aufgebracht. Das Klebemittel ist hierbei bevorzugt, ebenso wie die Barriere 5, aus einem Material beschaffen, welches die auszusendende beziehungsweise die zu detektierende Strahlung absorbiert. Im Idealfall ist die Strahlung vollständig absorbiert.

Bevorzugt ist in einer Ausführung die Dicke A des Oberteils der Barriere höchstens 0,3 mm, die Länge B des Oberteils der Barriere höchstens 0,8 mm, die Länge des Unterteils der Barriere höchstens 0,8 mm, der Strahlungsschatten 6 der Barriere höchstens 0,5 mm, die Dicke D des Unterteils der Barriere höchstens 0,3 mm und der Abstand E zwischen Barriere und aussendendem Halbleiterchip 3 höchstens 0,6 mm. Emitter 3 und Detektor 4 sind bevorzugt höchstens 1,2 mm voneinander entfernt. Der Emitter 3 ist bevorzugt ein Lambertscher Strahler. Durch das Ausformen der Barriere 5 in dieser Art ist ein Nebensprechen des Emitters 3 auf den Detektor 4 verhindert. Idealerweise ist das Material des Trägers 2 ebenfalls absorbierend für die auszusendende beziehungsweise zu detektierende Strahlung. Ein so genanntes Unterwandern der vom Emitter 3 erzeugten Strahlung der Barriere 5 ist demnach verhindert.

Als Emitter 3 ist beispielsweise eine Laserdiode oder eine LED vorzusehen. Als Detektor 4 ist beispielsweise ein Fototransistor, eine Fotodiode oder ein Fotowiderstand vorzusehen.

In den Figuren 2, 3 und 4 sind Ausführungsbeispiele der Lichtschranke dargestellt. In den Figuren 2, 3 und 4 sind jeweils ein zweiter Detektor 4 und eine weitere Barriere 5 auf der Oberseite 21 angeordnet. Die weitere Barriere 5 ist hierbei zwischen dem weiterem Detektor 4 und Emitter 3 angeordnet. Die Formgebungen der Barriere 5 nach Figuren 2,3 und 4 sind alternativ zur Formgebung der Barriere 5 aus Figur 1.

Mittels des weiteren Detektors 4 und der weiteren Barriere 5 können nun vereinfacht Aussagen darüber getroffen werden, ob ein Objekt im zu untersuchenden Bereich ist und wie die Relativlage des Objektes zum Emitter 3 ist. Da beide Detektoren 4 ein Leuchtdichtesignal beziehungsweise Strahldichtesignal auswerten, kann durch auswerten beider Signale ermittelt werden, ob sich das Objekt links, mittig oder rechts vom Emitter 3 befindet. Über die den Wert der Leuchtdichte lässt sich weiterhin aussagen, wie groß der Abstand F zwischen Objekt und Emitter 3 ist.

Der Signalverlauf der empfangenen Leuchtdichte beider Detektoren 4 bei unterschiedlichem Abstand F zwischen Halbleiterbauelement 1 und einem Objekt ist in der Figur 8 illustriert. In Figur 8 ist die Strahlungsdichte L in mW pro mm² über einen Bereich X in mm dargestellt. Der Bereich X ist bezogen auf den Emitter 3 dargestellt, der Punkt 0 mm X ist somit der Punkt, an dem sich der Emitter 3 befindet. Als Objekt wurde hierbei ein 20 mm x 20 mm weißes Papier verwendet. In Figur 8 wurde ein typischer Eingangsstrom von zirka 100 mA für den Emitter 3 verwendet und ein Detektor 4 eingesetzt der einen Fotostrom Iₚₕₒₜₒ in der Größenordnung von 10 µA detektieren kann.

Dieses weiße Papier ist oberhalb des Halbleiterbauelements 1 von links nach rechts bewegt worden. Im ersten Versuch wurde der Abstand F auf 5 mm festgesetzt. Die gestrichelten Linien stellen jeweils das empfangene Signal des linken Detektors 4, die durchgezogenen Linien das empfangene Signal des rechten Detektors 4 dar. Es ist eindeutig zu erkennen, dass in dem Bereich zwischen einschließlich -14 mm bis -7 mm lediglich der linke Detektor 4 eine Strahlungsdichte L detektiert, wohingegen im Bereich von +7 mm bis +14 mm nur der rechte Detektor 4 eine Strahlungsdichte L detektiert.

Befindet sich das Objekt in diesem Bereich, so ist ganz klar ermittelbar, wo relativ zum Emitter 3 das Objekt zu finden ist. Im Bereich zwischen -7 mm und +7 mm ist, bei einem Abstand des Objektes zum Halbleiterbauelement 1 von zirka 5 mm, ein Bereich vorgesehen, in dem beide Detektoren 4 detektieren und darauf geschlossen werden kann, dass das Objekt in der Mitte über dem Emitter 3 ist.

Es ist zu erkennen, dass der Betrag der Strahlungsdichte L über den Bereich von -7 mm bis +7mm bei einem Abstand F von 5 mm konstant ist. Man kann also in geringen Abständen F, hier beispielsweise 5 mm, davon ausgehen, dass ein quasi digitales Ausgangssignal an den Detektoren 4 zu erwarten ist. Wird der Abstand F vergrößert, beispielsweise 10 mm oder 20 mm, verändern sich die Kurven, wie in Figur 8 dargestellt. Man erkennt, dass der zu detektierende Bereich vergrößert ist, wobei allerdings die empfangene Leuchtdichte L verringert ist.

In einer dem Halbleiterbauelement 1 nachgeschalteten und nicht dargestellten Auswerteeinheit wird die Information bezüglich der beiden Detektoren 4 verglichen. Hierbei wird beispielsweise das Verhältnis aus der Strahlung vom linken Detektor 4 und dem rechten Detektor 4 gebildet. Beispielsweise durch Verhältnisbildung ist eine analoge Information erhältlich, die aussagt, in welchem Abstand F sich das Objekt befindet.

Die Barriere 5 kann mittels Spritzguss oder Spritzpressverfahren in ein Halbleiterbauelement 1 eingebracht sein. Hierbei ist es vorteilhaft wenn die Barriere 5 ein Teil des Gehäuseunterteils ist.

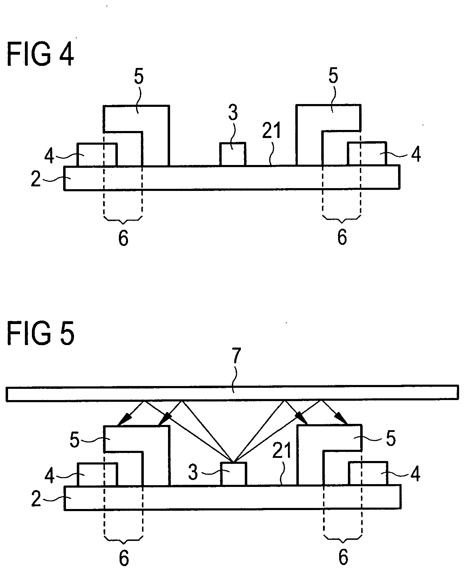

In Figur 5 ist eine Weiterbildung des in Figur 4 dargestellten Ausführungsbeispiels dargestellt. Im Unterschied zu Figur 4 ist in Figur 5 eine Abdeckung 7 oberhalb des Halbleiterbauelements in den Strahlengang der Halbleiterchips 3,4 eingebracht. Die Abdeckung 7 ist in einer Ausführung ein Glas. Alternativ ist die Abdeckung 7 ein optisches Element. Ein Teil der ausgesendeten elektromagnetischen Strahlung des Emitters 3 wird an der Oberfläche der Glasabdeckung 7 reflektiert.

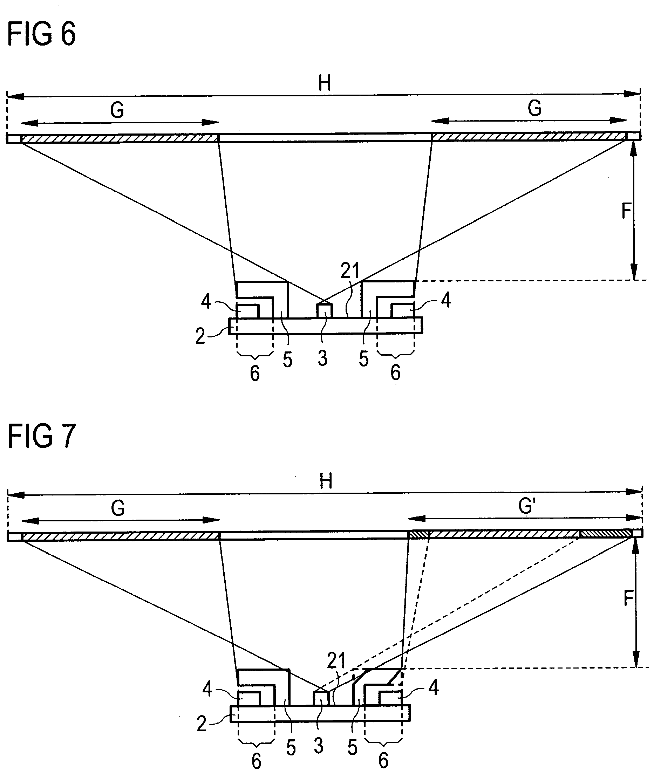

Durch Ausgestalten der Barriere 5 in der bereits beschriebenen Art und Weise ist ein direktes Einkoppeln des Emitters 3 auf den Detektor 4 nicht mehr gegeben. Das Übersprechen von Emitter 3 und Detektor 4 ist somit sehr stark reduziert. Dadurch ist die Empfindlichkeit des Detektors 4 stark erhöht. In Figur 6 ist ein zu detektierender Bereich dargestellt. Dieser Bereich wird mit einem Halbleiterbauelement 1 aus Figur 4 überwacht. Befindet sich ein Objekt im zu untersuchenden Bereich, so wird die vom Emitter 3 ausgesendete Strahlung an der Oberfläche des Objektes reflektiert. In Figur 6 ist nun dargestellt, in welchen Bereichen G der Detektor 4 sensitiv ist und der jeweils linke beziehungsweise rechte Detektor 4 eine zu detektierende Strahlung empfangen. Ein zu erwartende Signalverlauf der Leuchtdichte an den beiden Detektoren 4 ist qualitativ mit dem in Figur 8 dargestellt Signalverlauf vergleichbar.

Zur Vergrößerung des sensitiven Bereiches G ist in Figur 7 ein weiteres Ausführungsbeispiel einer Barriere 5 dargestellt. Es ist zu erkennen, dass durch Abschrägen von Kanten des Oberteils der Barriere 5 der sensitive Bereich G' entsteht. Dieser Bereich G' ist betragsmäßig größer als der Bereich G eines nicht abgeschrägten Oberteils der Barriere 5. Diese Bereichsvergrößerung ist signifikant, obwohl das Nebensprechen und die Umwelteinflüsse weiterhin minimiert bleiben.

Es ist auch möglich, dass keiner der beiden Detektoren 4 eine Strahlung empfängt, wenn sich das Objekt direkt über dem Emitter 3 befindet. Dieser Bereich wird als Blindbereich bezeichnet und befindet sich zwischen den beiden sensitiven Gebieten G.

In Figur 9 ist ein weiteres Ausführungsbeispiel dargestellt. Hier finden sich drei Detektoren 4 in dem Halbleiterbauelement, die ein bevorzugt gleichseitiges Dreieck aufspannen. Innerhalb des aufgespannten Dreiecks ist der Emitter 3 angeordnet. Zwischen Emitter 3 und den Detektoren 4 ist eine ringförmige Barriere 5 eingebracht, die derart ausgeformt ist, dass sie die Eigenschaften, wie unter Figur 1 beschrieben erzielt. Durch die Anordnung nach Figur 9 ist die Auflösung des zu detektierenden Bereiches erhöht.

In Figur 10 ist ein weiteres Ausführungsbeispiel eines Halbleiterbauelements 1 dargestellt. Hierbei ist das Oberteil der Barriere 5 nicht rechtwinklig zum Unterteil der Barriere 5 angeordnet, sondern in einem bestimmten Winkel angebracht. Auch diese Ausgestaltung führt, ähnlich zu dem Ausführungsbeispiel gemäß der Figur 7, zu einer Bereichsvergrößerung G', ohne das Nebensprechen oder den Einfluss der Umweltgrößen zu erhöhen.

In den Figuren 11 und 12 ist hierbei der dargestellte Fotostrom Iₚₕₒₜₒ des linken beziehungsweise rechten Detektors 4 aus Figur 10 dargestellt. In Figur 11 ist der Fotostrom Iₚₕₒₜₒ mittels Messung, in Figur 12 hingegen mittels Simulation erhalten. Grundsätzlich lässt sich aussagen, dass die Simulation mit der Messung qualitativ übereinstimmt. Bezüglich der Deutung der Signalverläufe ist an dieser Stelle insbesondere auf Figur 8 verwiesen. Anzumerken ist, dass durch die abgewinkelte Barriere 5 aus Figur 10 der Bereich oberhalb des Emitters 3 stärker überwacht ist, als beispielsweise mit einer Barriere 5 aus Figur 4.

Wie in den Figuren 10, 11 dargestellt, ist die Höhe beziehungsweise der Abstand F zwischen Objekt und dem Halbleiterbauelement 1 dafür verantwortlich, wie viel Strahlung vom detektierenden Halbleiterchip 4 noch empfangen wird. Ist das Objekt weiter vom Halbleiterbauelement 1 entfernt, so ist eine geringere Leuchtdichte L am Detektor 4 zu erwarten. Durch Verwenden eines dritten Detektors, wie in Figur 9 dargestellt, ist diese zweidimensionale Erkennung verbessert. Durch Einbringen weiterer Detektoren 4 und Emitter 3 ist der jeweilige Bereich verbessert aufgelöst.

Die vom Emitter 3 ausgesendeten Impulse werden in einem Ausführungsbeispiel amplitudenmoduliert. Dadurch werden diese Strahlungsimpulse weniger von Umwelteinflüßen verändert. Grundsätzlich ist anzustreben, die Strahlung in Impulsform zu versenden, um den Energiebedarf des Halbleiterbauelements 1 zu senken.

Das Halbleiterbauelement 1 ist für eine Verwendung als Lichtschranke vorgesehen. Als Näherungssensor oder auch als Fingerprintsensor ist dieses Halbleiterbauelement 1 ebenfalls vorzusehen.

Weiterhin ist ein Verfahren zum Detektieren von Objekten mittels eines beschriebenen Halbleiterbauelements vorgesehen, wobei die Leuchtdichte im Detektor 4 in einer nachgeschalteten Auswerteeinheit ausgewertet wird und aufgrund der Höhe der Leuchtdichte auf die Entfernung des Objektes zum Halbleiterbauelement 1 geschlossen wird. Die Leuchtdichte ist hierbei ein Maß für die Intensität der im Detektor 4 ermittelten Strahlung.

Bei der nicht-erfindungsgemäßen Abwandlung der Lichtschranke gemäß Figur 13 ist das richtungsselektive Element 8, das als Linsenkörper ausgeformt ist, über den Emittern 3 angebracht, von der Oberseite 21 aus gesehen. Beispielsweise ist das richtungsselektive Element 8 durch ein Vergießen der Emitter 3 erzeugt. Durch das richtungsselektive Element 8 wird vom Emitter 3 erzeugte Strahlung, in Figur 13 durch Pfeil-Linien angedeutet, jeweils in einer lateralen Richtung weg von dem Detektor 4 gelenkt. Ein Material des richtungsselektiven Elements 8, beispielsweise ein Silikon oder ein thermoplastischer Kunststoff, befindet sich bevorzugt in direktem physischem Kontakt mit einem Material des Halbleiterchips 3.

Es ist möglich, dass die Emitter 3 Strahlung mit voneinander verschiedenen Wellenlängen aussenden, auch in Kombination mit Wellenlängenfiltern an dem Detektor 4. Alternativ oder zusätzlich können die Emitter 3 in einem Multiplexverfahren, insbesondere in einem Zeitmultiplexverfahren, betrieben werden.

Bei der nicht-erfindungsgemäßen Abwandlung gemäß Figur 14 ist das richtungsselektive Element 8 jeweils durch ein Strahlung durchlässiges Prisma gebildet, das den Detektoren 4 nachgeordnet ist. Durch die lichtbrechende Wirkung des Prismas gelangt jeweils nur vom Emitter 3 generierte Strahlung aus einem bestimmten Raumwinkelbereich, etwa über Reflexion an einem nicht gezeichneten Objekt, zu den Detektoren 4, in Figur 14 symbolisiert durch Pfeil-Linien.

Eine nicht dargestellte Halterung des richtungsselektiven Elements 8, mittels der dieses an dem Träger 2 befestigt ist, kann jeweils als eine Abschirmung ausgeformt sein, die sich zwischen dem Detektor 4 und dem Emitter 3 befindet. Über die Halterung kann dann verhindert werden, das Strahlung direkt vom Emitter 3 ohne Reflexion an einem nicht gezeichneten Objekt zum Detektor 4 gelangt.

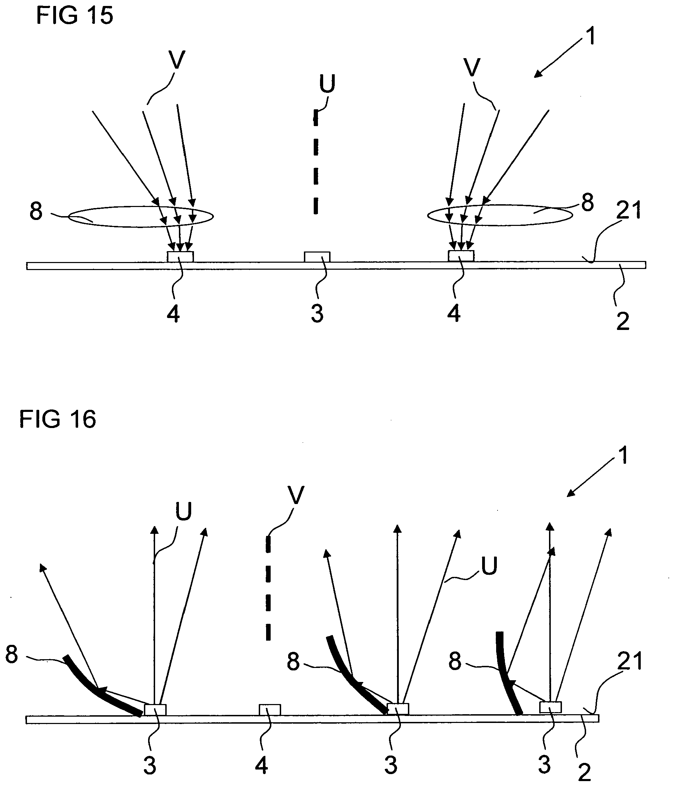

Bei der nicht-erfindungsgemäßen Abwandlung der Lichtschranke gemäß Figur 15 sind die richtungsselektiven Elemente 8 des Halbleiterbauteils 1 jeweils durch Sammellinsen realisiert, anstelle der Prismen gemäß der Abwandlung nach Figur 14. Anders als in Figur 15 dargestellt, kann es sich bei dem richtungsselektiven Element 8 anstelle einer Sammellinse auch um eine Fresnel-Linse handeln.

Bei der nicht-erfindungsgemäßen Abwandlung in Figur 16 sind die richtungsselektiven Elemente 8 jeweils durch Reflektoren gebildet. Ein Teil der Reflektoren 8 kann sich hierbei zwischen dem Detektor 4 und dem jeweiligen, zugeordneten Emitter 3 befinden. Anders als in Figur 16 dargestellt, ist es ebenso möglich, dass die Reflektoren 8 nicht voneinander verschieden, sondern zueinander baugleich geformt sind. Die Reflektoren 8 können sich hierbei in direktem Kontakt zu dem zugehörigen Emitter 3 befinden oder auch von dem Emitter 3 räumlich separiert sein. Eine dem zugeordneten Emitter 3 abgewandte Seite des Reflektors 8 kann mit einer für die von den Emittern 3 ausgesandte Strahlung absorbierend wirkenden Beschichtung versehen sein, um eine Streustrahlung, die zu dem Detektor 4 gelangen kann, zu reduzieren oder zu unterbinden. Keine zwei der Hauptstrahlachsen U, V weisen dieselbe Orientierung, bezogen auf die Oberseite 21, auf.

Die hier beschriebene Erfindung ist nicht durch die Beschreibung anhand der Ausführungsbeispiele beschränkt. Die Erfindung ist durch die nachfolgenden Ansprüche definiert.

## Patentansprüche

1. Lichtschranke mit einem Halbleiterbauelement(1), bei der das Halbleiterbauelement (1) aufweist:
- einen Träger(2),
- zumindest zwei auf einer Oberseite (21) des Trägers (2) aufgebrachte und eine elektromagnetische Strahlung detektierende Halbleiterchips (4),
- zumindest einen eine elektromagnetische Strahlung aussendenden Halbleiterchip (3), der an der Oberseite (21) des Trägers (2) angebracht ist, und
- mindestens zwei an der Oberseite (21) des Trägers (2) angebrachte richtungsselektive Elemente (5), die einen Winkelbereich der von den detektierenden Halbleiterchips (4) empfangbaren Strahlung eingrenzen,
wobei Hauptstrahlachsen (V) der empfangbaren Strahlung gegenüber einer Hauptstrahlachse (U) der zu emittierenden Strahlung jeweils verkippt sind,
wobei
- die richtungsselektiven Elemente je durch eine Barriere (5) aus einem für die zu detektierende, vom aussendenden Halbleiterchip (3) ausgesandte elektromagnetische Strahlung undurchlässigen Material gebildet sind,
- die Barrieren (5) jeweils beabstandet vom zugehörigen detektierenden Halbleiterchip (4) sind,
- die Barrieren (5) derart geformt sind, dass bei senkrechter Parallelprojektion der Barrieren (5) und der detektierenden Halbleiterchips (4) auf die Oberseite (21) des Trägers (2) die projizierte Fläche der Barrieren (5) und die projizierte Fläche der detektierenden Halbleiterchips (4) zumindest teilweise überlappen, sodass ein Strahlungsschatten (6) bei senkrecht auf die Oberseite (21) treffender Strahlung entsteht, der die detektierenden Halbleiterchips (4) zumindest teilweise bedeckt,
- sich die Barrieren (5) je zwischen dem aussendenden Halbleiterchip (3) und dem zugehörigen detektierenden Halbleiterchip (4) befinden, und
- sich zwischen sensitiven Gebieten (G), in denen die elektromagnetische Strahlung detektierenden Halbleiterchips (4) sensitiv sind, ein Blindbereich befindet, aus dem keiner der detektierenden Halbleiterchips (4) die vom aussendenden Halbleiterchip (3) ausgesandte elektromagnetische Strahlung empfängt, wenn sich ein zu detektierendes Objekt direkt über dem aussendenden Halbleiterchip (3) befindet.

2. Lichtschranke nach dem vorhergehenden Anspruch, wobei die Hauptstrahlachsen (U, V) zwischen einschließlich 15° und 45° gegeneinander verkippt sind.

3. Lichtschranke nach einem der vorhergehenden Ansprüche, wobei die Barrieren (5) mittels eines Klebemittels auf die Oberseite (21) des Trägers (2) angebracht sind.

4. Lichtschranke nach einem der vorhergehenden Ansprüche, wobei zumindest zwei die Strahlung aussendende Halbleiterchips (3) auf der Oberseite (21) des Trägers (2) angeordnet sind und die aussendenden Halbleiterchips (3) amplitudenmodulierte oder nicht amplitudenmodulierte Strahlungsimpulse in einem Zeitmultiplexverfahren aussenden.

5. Lichtschranke nach einem der vorhergehenden Ansprüche, wobei die Barrieren (5) L-förmig, bogenförmig und/oder schräg geformt sind.

6. Lichtschranke nach einem der vorhergehenden Ansprüche, wobei zumindest ein optisches Element (7) zur verbesserten Strahlführung oberhalb zumindest eines der Halbleiterchips (3, 4) im Strahlengang des jeweiligen Halbleiterchips (3, 4) angeordnet ist.

7. Lichtschranke nach einem der vorhergehenden Ansprüche, wobei die die Strahlung detektierenden Halbleiterchips (4) je ein applikationsspezifischer integrierter Schaltkreis, ein Fototransistor, eine Fotodiode oder ein Fotowiderstand sind.

8. Lichtschranke nach einem der vorhergehenden Ansprüche, wobei der die Strahlung aussendende Halbleiterchip (3) eine Laserdiode oder eine LED ist.

9. Verfahren zum Detektieren von Objekten mittels einer Lichtschranke nach Anspruch 1 bis 8, wobei die Intensität der in den Halbleiterchips (4) detektierten Strahlung in einer nachgeschalteten Auswerteeinheit ausgewertet wird und aufgrund der Höhe der Intensität auf die Entfernung des Objektes zum Halbleiterbauelement (1) geschlossen wird, und wobei
- in der Auswerteeinheit die Intensitäten der mindestens zwei detektierenden Halbleiterchips (4) ausgewertet werden, und
- aufgrund der Intensitäten der detektierten Strahlung die relative Position des Objektes zu einem die Strahlung aussendenden Halbleiterchip (3) bestimmt wird.

10. Verfahren nach dem vorhergehenden Anspruch, wobei die Auflösung zum Detektieren des Objektes durch Verwendung weiterer aussendender (3) und/oder detektierender Halbleiterchips (4) erhöht wird, und wobei die Empfindlichkeit zum Detektieren von Objekten durch Verwendung von optischen Elementen (7) im Strahlengang der Halbleiterchips (3, 4) erhöht wird.

## Claims

1. Light barrier with a semiconductor component (1), the semiconductor component (1) having:
- a carrier (2),
- at least two semiconductor chips (4) applied on a top side (21) of the carrier (2) and detecting electromagnetic radiation,
- at least one semi-conductor chip (3) emitting electromagnetic radiation, attached to the top side (21) of the carrier (2), and
- at least two directionally selective elements (5) attached to the top side (21) of the carrier (2), delimiting an angular portion of the radiation, which can be received by the detecting semiconductor chips (4),
wherein main beam axes (V) of the receivable radiation are each tilted with respect to a main beam axis (U) of the radiation to be emitted,
wherein
- the directionally selective elements are each formed by a barrier (5) of a material, which is impermeable to the electromagnetic radiation to be detected, emitted by the emitting semiconductor chip (3),
- the barriers (5) are each spaced apart from the associated detecting semi-conductor chip (4),
- the barriers (5) are shaped in such a way that with perpendicular parallel projection of the barriers (5) and of the detecting semiconductor chips (4) on the top side (21) of the carrier (2), the projected area of the barriers (5) and the projected area of the detecting semiconductor chips (4) overlap at least partially, such that a radiation shadow (6) forms with radiation hitting perpendicularly on the top side (21), covering the detecting semiconductor chips (4) at least partially,
- the barriers (5) are each located between the emitting semiconductor chip (3) and the associated detecting semiconductor chip (4), and
- a dummy portion is located between sensitive regions (G), in which the semiconductor chips (4) detecting electromagnetic radiation are sensitive, and from which none of the detecting semiconductor chips (4) receive the electromagnetic radiation emitted by the emitting semiconductor chip (3), if an object to be detected is located directly above the emitting semiconductor chip (3).

2. Light barrier according to the preceding claim, wherein the main beam axes (U, V) are tilted with respect to one another between inclusively 15° and 45°.

3. Light barrier according to one of the preceding claims, wherein the barriers (5) are applied by means of an adhesive on the top side (21) of the carrier (2).

4. Light barrier according to one of the preceding claims, wherein at least two semiconductor chips (3) emitting the radiation are disposed on the top side (21) of the carrier (2), and the emitting semiconductor chips (3) emit amplitude-modulated or non-amplitude-modulated radiation pulses in a time-division multiplex method.

5. Light barrier according to one of the preceding claims, wherein the barriers (5) are L-shaped, arc-shaped and/or obliquely shaped.

6. Light barrier according to one of the preceding claims, wherein at least one optical element (7) for improved beam guidance is disposed above at least one of the semiconductor chips (3, 4) in the beam path of the respective semiconductor chip (3, 4).

7. Light barrier according to one of the preceding claims, wherein the semiconductor chips (4) detecting the radiation are each an application-specific integrated circuit, a phototransistor, a photodiode, or a photoresistor.

8. Light barrier according to one of the preceding claims, wherein the semiconductor chip (3) emitting the radiation is a laser diode or a LED.

9. Method for detecting objects by means of a light barrier according to claim 1 to 8, wherein the intensity of the radiation detected in the semiconductor chips (4) is evaluated in a downstream evaluation unit and is concluded based on the level of intensity on the removal of the object from the semiconductor component (1), and wherein
- the intensities of the at least two detecting semiconductor chips (4) are evaluated in the evaluation unit, and
- the relative position of the object relative to a semiconductor chip (3) emitting the radiation is determined based on the intensities of the detected radiation.

10. Method according to the preceding claim, wherein the resolution for detecting the object is increased by using further emitting (3) and/or detecting semiconductor chips (4), and wherein the sensitivity for detecting objects is increased by using optical elements (7) in the beam path of the semiconductor chips (3, 4).

## Revendications

1. Barrière optique avec un composant semi-conducteur (1), le composant semi-conducteur (1) comportant :
- un support (2),
- au moins deux puces semi-conductrices (4) appliquées sur un côté supérieur (21) du support (2) et détectant un rayonnement électromagnétique,
- au moins une puce semi-conductrice (3) émettant un rayonnement électromagnétique et agencée au côté supérieur (21) du support (2), et
- au moins deux éléments sélectionneurs de direction (5) agencés au côté supérieur (21) du support (2) et délimitant une portion angulaire du rayonnement qui peut être reçu par les puces semi-conductrices de détection (4),
dans laquelle des axes de faisceau principaux (V) du rayonnement recevable sont inclinés chacun par rapport à un axe de faisceau principal (U) du rayonnement à émettre,
dans laquelle
- les éléments sélectionneurs de direction sont formés chacun par une barrière (5) d'un matériau imperméable au rayonnement électromagnétique à détecter et émis par la puce semi-conductrice émettrice (3),
- les barrières (5) sont chacune espacées de la puce semi-conductrice de détection (4) associée,
- les barrières (5) sont formées si bien que lors d'une projection parallèle perpendiculaire des barrières (5) et des puces semi-conductrices de détection (4) sur le côté supérieur (21) du porteur (2), la zone projetée des barrières (5) et la zone projetée des puces semi-conductrices de détection (4) chevauchent au moins partiellement, si bien qu'une ombre de rayonnement (6) est créée lors d'un rayonnement touchant perpendiculairement sur le côté supérieur (21), recouvrant les puces semi-conductrices de détection (4) au moins partiellement,
- les barrières (5) se trouvent chacune entre la puce semi-conductrice émettrice (3) et la puce semi-conductrice de détection (4) associée, et
- une partie aveugle est située entre des régions sensitives (G) dans lesquelles les puces semi-conductrices (4) détectant un rayonnement électromagnétique sont sensitives, et d'où aucune des puces semi-conductrices de détection (4) ne reçoit le rayonnement électromagnétique émis par la puce semi-conductrice émettrice (3) lorsqu'un objet à détecter est situé immédiatement au-dessus de la puce semi-conductrice émettrice (3).

2. Barrière optique selon la revendication précédente, dans laquelle les axes de faisceau principaux (U, V) sont inclinés l'un vers l'autre dans un angle compris entre 15° et 45°.

3. Barrière optique selon l'une des revendications précédentes, dans laquelle les barrières (5) sont appliquées au moyen d'un adhésif sur le côté supérieur (21) du support (2).

4. Barrière optique selon l'une des revendications précédentes, dans laquelle au moins deux puces semi-conductrices émettrices de rayonnement (3) sont agencées sur le côté supérieur (21) du support (2) et les puces semi-conductrices émettrices (3) émettent des impulsions de rayonnement modulées en amplitude ou non dans un procédé en multiplexage temporel.

5. Barrière optique selon l'une des revendications précédentes, dans laquelle les barrières (5) sont en forme de L, en forme d'arc et / ou en forme inclinée.

6. Barrière optique selon l'une des revendications précédentes, dans laquelle au moins un élément optique (7) pour un guidage de faisceau amélioré est disposé au-dessus d'au moins une des puces semi-conductrices (3, 4) dans le trajet de faisceau de la puce semi-conductrices (3, 4) respective.

7. Barrière optique selon l'une des revendications précédentes, dans laquelle les puces semi-conductrices (4) détectant le rayonnement sont chacune un circuit intégré à application spécifique, un phototransistor, une photodiode ou une photorésistance.

8. Barrière optique selon l'une des revendications précédentes, dans laquelle la puce semi-conductrice émettrice de rayonnement (3) est une diode laser ou une LED.

9. Procédé de détection d'objets au moyen d'une barrière optique selon les revendications 1 à 8, dans lequel l'intensité du rayonnement détecté dans la puce semi-conductrice (4) est évaluée dans une unité d'évaluation en aval et est fermée en raison de la quantité d'intensité sur la distance de l'objet au composant semi-conducteur (1), et dans lequel
- les intensités des au moins deux puces semi-conductrices de détection (4) sont évaluées dans l'unité d'évaluation, et
- en raison des intensités du rayonnement détecté, la position relative de l'objet par rapport à une puce semi-conductrice émettrice de rayonnement (3) est déterminée.

10. Procédé selon la revendication précédente, dans lequel la résolution pour détecter l'objet est augmentée en utilisant en outre des puces semi-conductrice émettrices (3) et / ou de détection (4), et dans lequel la sensibilité pour détecter des objets en utilisant des éléments optiques (7) est augmentée dans le trajet de faisceau des puces semi-conductrices (3, 4).
